# EUROPEAN PATENT SPECIFICATION

(11) **EP 2 574 159 B1**
(45) Date of publication and mention of the grant of the patent: **21.02.2018**
(21) Application number: 11783574.4
(22) Date of filing: 18.05.2011
(51) Int. Cl.: H05K 7/20, H01L 23/427, H01L 23/467, F28F 3/02, F28D 15/02, H01L 23/367, F28F 1/32

(54) **COOLING DEVICE WITH A PLURALITY OF FIN PITCHES**
KÜHLVORRICHTUNG MIT MEHREREN RIPPENSPITZEN
DISPOSITIF DE REFROIDISSEMENT AVEC UNE PLURALITÉ DE PAS DES AILETTES

(30) Priority: 18.05.2010 JP 2010114357
(43) Date of publication of application: 27.03.2013
(73) Proprietor: Furukawa Electric Co., Ltd., Chiyoda-ku Tokyo 100-8322 (JP)
(72) Inventor: FUKAI Hiroyuki, Tokyo 100-8322 (JP); HASHIMOTO Nobuyuki, Tokyo 100-8322 (JP); YAMADA Hiroshi, Tokyo 100-8322 (JP); IKEDA Masami, Tokyo 100-8322 (JP); SHIMADA Mamoru, Tokyo 100-8322 (JP)
(74) Representative: Zech, Stefan Markus
(86) International application number: PCT/JP2011/061365
(87) International publication number: WO 2011/145640

(56) References cited:
- WO-A1-03/073023
- JP-A- 6 276 741
- JP-A- 2000 161 880
- JP-A- 2001 024 122
- JP-A- 2003 188 321
- JP-A- 2003 188 321
- JP-A- 2006 024 661
- JP-A- 2007 208 116
- JP-A- 2007 208 116
- US-A1- 2007 053 166

## Description

### [Technical Field]

The present invention relates to a cooling device for cooling a heat-generating element by forced-air cooling, and more particularly to a cooling device that performs forced-air cooling to cool such electronic components as power conversion devices mounted on transportation means including railroad vehicles, aircrafts and ships. A cooling device according to the preamble of claim 1 and 2 is known from JP 2007 - 208116.

### [Background Art]

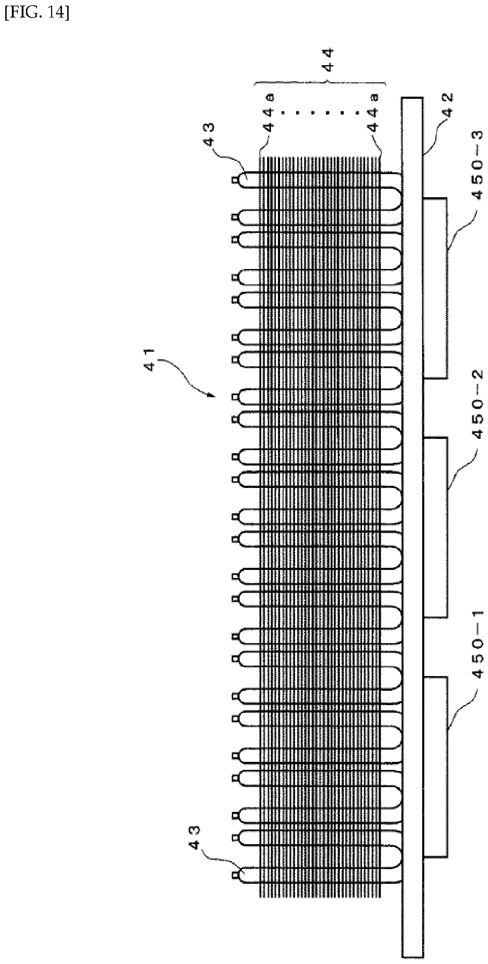

Conventional cooling devices include electronic component cooling devices in housings (hereinafter referred to as the conventional example) shown in Fig. 14. This conventional example comprises a flat plate-shaped heat-receiving block 42; a plurality of heat pipes 43 with a U-shape in side view erected on a surface of the heat-receiving block 42; and a heat radiation fin group 44. The heat radiation fin group 44 has a plurality of fins 44a mounted on the heat pipes 43 in the direction parallel to the heat-receiving block 42, and all the fin pitches between the respective fins 44a are equal (Patent Document 1).

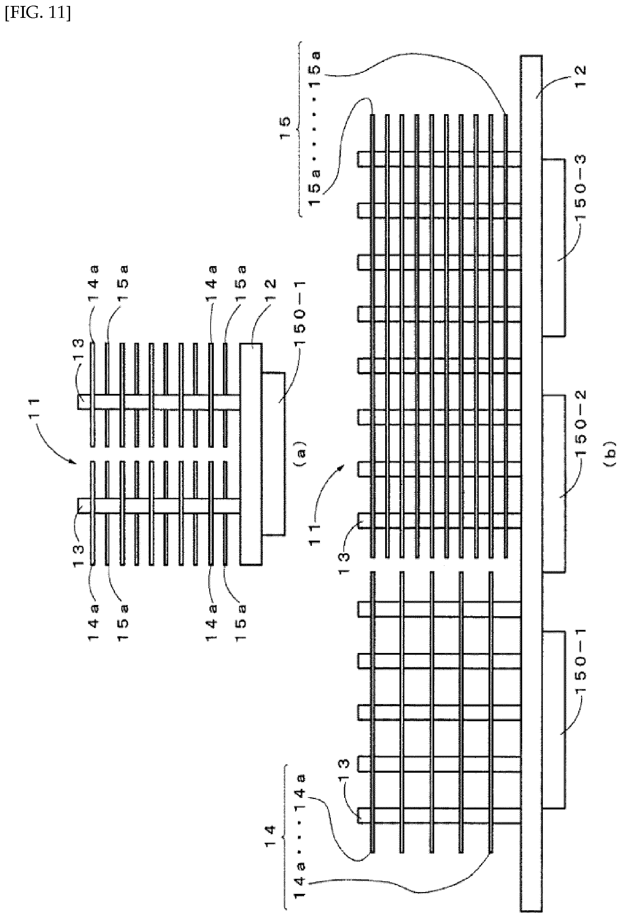

In the case of the cooling device 41 of the conventional example, where the fins 44a has a longer side in the flow direction of cooling air, the flow velocity of the cooling air flowing between the fins 44a is significantly reduced as the cooling air travels leeward. Therefore, in the cooling device 41 of the conventional example, the cooling capacity greatly varies between the leeward side and the windward side. For example, a problem arises when a plurality (three, in Fig. 14) of heat-generating elements 450-1, 450-2, 450-3 are thermally connected to the heat-receiving block 42 and cooling air is supplied in parallel with a surface of the heat-receiving block 42 - i.e., in the left-to-right direction of Fig. 11. Specifically, the aforementioned problem is that since the heat-generating element 450-3 arranged on the most leeward side is poorly cooled as compared with the heat-generating element 450-1 arranged on the most windward side, the temperature decrease of the heat-generating element 450-3 is suppressed.

In order to increase the cooling capacity on the leeward side, it is necessary to increase the number of fins 44a to be installed or the amount of cooling air. However, there is a problem that an increased number of fins 44a results in an increase in the dimensions as well as the weight of the cooling device. There is a further problem that manufacturing costs are increased. Furthermore, in order to increase the amount of cooling air, it is only necessary to provide a powerful fan. However, its large size presents the following problems: it is difficult to secure a space for installation; and power consumption for driving the fan is large.

### [Prior Art Document]

### [Patent Document]

[Patent Document 1]
JP Patent Appl. Publ. No. 9-119785

### [Summary of the Invention]

### [Problems to be Solved by the Invention]

The present invention was made in view of the aforementioned problems of the conventional art and is aimed at providing a cooling device with an increased leeward cooling capacity without increasing the number of heat radiation fins to be installed or the amount of cooling air.

### [Means for Solving the Problems]

A first embodiment of the present invention is a cooling device including a heat-receiving block thermally connected to a heat-generating element and heat radiation fin groups. The heat radiation fin groups have a plurality of fins thermally connected to the heat-receiving block, and a flow of the cooling air is set in the direction parallel to the heat-receiving block. The cooling device is characterized in that the plurality of heat radiation fin groups are arranged in tandem along the flow direction of the cooling air, and that of the plurality of heat radiation fin groups, the fin pitch of the heat radiation fin group arranged on the windward side of the cooling air is larger than the fin pitch of the heat radiation fin group arranged on the leeward side of the cooling air. A second embodiment of the present invention is a cooling device including a heat-receiving block thermally connected to a heat-generating element and heat radiation fin groups having a plurality of fins erected on a surface of the heat-receiving block wherein a flow of the cooling air is set in the direction parallel to the heat-receiving block. The cooling device is characterized in that the plurality of heat radiation fin groups are arranged in tandem along the flow direction of the cooling air, and that of the plurality of heat radiation fin groups, the fin pitch of the heat radiation fin group arranged on the windward side of the cooling air is larger than the fin pitch of the heat radiation fin group arranged on the leeward side of the cooling air.

A third embodiment of the present invention is a cooling device including a heat-receiving block thermally connected to a heat-generating element, a plurality of heat pipes erected on a surface of the heat-receiving block, and heat radiation fin groups having a plurality of fins mounted on the heat pipes in the direction parallel to the heat-receiving block wherein a flow of the cooling air is set in the direction parallel to the heat-receiving block. The cooling device is characterized in that the plurality of heat radiation fin groups are arranged in tandem along the flow direction of the cooling air, and that of the plurality of heat radiation fin groups, the fin pitch of the heat radiation fin group arranged on the windward side of the cooling air is larger than the fin pitch of the heat radiation fin group arranged on the leeward side of the cooling air.

In each aforementioned embodiment, a plurality of heat radiation fin groups are disposed in parallel or substantially in parallel with the flow direction of the cooling air. Furthermore, each fin constituting the heat radiation fin group is mounted such that a surface thereof is in parallel or substantially in parallel with the flow direction of the cooling air. In this way, the fins are configured such that cooling air smoothly flows between the fins. The fin pitches of the fins constituting one heat radiation fin group are the same or nearly the same. However, the heat radiation fin groups are configured such that different groups have different fin pitches, i.e., the fin pitch between adjacent fins varies from one heat radiation fin group to another. The fin pitch of the heat radiation fin group arranged on the windward side of the cooling air is larger than the fin pitch of the heat radiation fin group arranged on the leeward side of the cooling air.

As described above, the fin pitch of the heat radiation fin group on the windward side is set larger than the fin pitch of the heat radiation fin group on the leeward side. When one fan is used in this setting, the amount and velocity of the cooling air passing through the windward heat radiation fin group can be prevented from being reduced and a temperature rise of the cooling air also can be suppressed. In addition, since a temperature rise of the cooling air on the windward side can be suppressed, the cooling air with a lower temperature can be supplied to the leeward heat radiation fin group. Herein, the term "heat radiation fin group" is defined as a group of a plurality of fins where each fin is arranged in the direction vertical to the flow direction of the cooling air.

A fourth embodiment of the present invention is a cooling device characterized in that the fin pitch of the heat radiation fin group arranged on the windward side is an integer multiple of the fin pitch of the heat radiation fin group arranged on the leeward side. By setting the fin pitch of one heat radiation fin group to an integer multiple of the fin pitch of an adjacent group, it is possible to align the phases of the fin pitches between the heat radiation fin groups so that a pressure loss of the cooling air flowing along the heat radiation fin groups due to the fins can be suppressed.

A fifth embodiment of the present invention is a cooling device characterized in that the length of the fins of the heat radiation fin group arranged on the windward side is shorter than the length of the fins of the heat radiation fin group arranged on the leeward side.

A sixth embodiment of the present invention is a cooling device characterized in that the heat pipes are U-shaped or L-shaped in side view.

### [Advantages of the Invention]

According to the first, the second and the third embodiments of the present invention, a pressure loss of the cooling air due to the windward heat radiation fin group is suppressed, and the amount and velocity of the cooling air passing through the heat radiation fin group on the leeward side can be prevented from being reduced. The cooling capacity on the leeward side is thereby increased so that the cooling capacity can be made uniform across the windward side and the leeward side. Since the cooling capacity can be made uniform, even a large-scale cooling device with a long fin length can without fail provide a cooling capacity across the windward side and the leeward side. In addition, since the number of fins of the windward heat radiation fin group is reduced, it is possible to suppress a temperature rise of the cooling air on the windward side and to supply the cooling air with a lower temperature to the leeward heat radiation fin group. The cooling capacity on the leeward side can be thereby increased. The fin pitch of the windward heat radiation fin group is large, i.e., the number of fins to be installed can be reduced as compared with the conventional example. Therefore, the cooling device can be reduced in size and weight as well as in manufacturing cost. Further, since it is not necessary to install a powerful fan in order to increase the cooling capacity on the leeward side, a space can be saved for installation, and the power consumption for driving the fan can be reduced to decrease environmental loads.

According to the third embodiment of the present invention, heat pipes are provided. In addition to the aforementioned effects, the cooling capacity is further increased for all the groups from the windward heat radiation fin group to the leeward heat radiation fin group.

According to the fourth embodiment of the present invention, a pressure loss of the cooling air due to the fins is suppressed. Further. the cooling air flowing between the fins of the respective heat radiation fin groups can be made uniform so that it is possible to efficiently supply cooling air to the respective heat radiation fin groups. In addition, since cooling air can be efficiently supplied to the heat radiation fin groups, the cooling capacity of the leeward heat radiation fin group can be further increased so that the heat-generating element can be cooled without fail even in an enclosed space, e.g., inside the housing of a vehicle.

According to the fifth embodiment of the present invention, the length of the fins of the windward heat radiation fin group is shorter than the length of the fins of the leeward heat radiation fin group. While the windward heat radiation fin group with a higher cooling capacity can be reduced in size and weight, the cooling capacity of the leeward heat radiation fin group can be increased. Further, by properly adjusting the length of the fins of the windward heat radiation fin group and the leeward heat radiation fin group, the cooling capacity of all the portions of the cooling device can be made as uniform as possible.

According to the sixth embodiment of the present invention, since the heat pipes are U-shaped or L-shaped in side view, the fins can be mounted effortlessly. The number of fins to be installed and the fin pitch can be properly adjusted, depending on the operation conditions of the cooling device.

### [Brief Description of Drawings]

Fig. 1 is a side view of a cooling device according to the first embodiment of the present invention, where the cooling device is mounted with a heat-generating element.
Fig. 2 is an explanatory diagram illustrating a flow of cooling air of a cooling device according to the first embodiment of the present invention.
Fig. 3 is an explanatory diagram illustrating a flow of cooling air of a cooling device.
Fig. 4 is a graph comparing a temperature rise of a heat-generating element of a cooling device according to the first embodiment of the present invention with a temperature rise of a heat-generating element of a cooling device of the conventional example.
Fig. 5 is a graph explaining a method of positioning a gap between heat radiation fin groups where two heat radiation fin groups are arranged.
Fig. 6 is a side view of a cooling device according to the third embodiment of the present invention, where the cooling device is mounted with a heat-generating element.
Fig. 7 is a side view of a cooling device according to the second embodiment of the present invention, where the cooling device is mounted with a heat-generating element.
Fig. 8(a) is a cross-sectional explanatory diagram of a first heat radiation fin group of Fig. 7, Fig. 8(b) is a cross-sectional explanatory diagram of a second heat radiation fin group of Fig. 7, and Fig. 8(c) is a cross-sectional explanatory diagram of a third heat radiation fin group of Fig. 7.
Fig. 9 is a graph comparing a temperature rise of a heat-generating element of a cooling device according to the third embodiment of the present invention with a temperature rise of a heat-generating element of a cooling device of the conventional example.
Fig. 10 is a graph explaining a method of positioning gaps between heat radiation fin groups where three heat radiation fin groups are arranged.
Fig. 11(a) is a front view of a cooling device using a heat transfer block, where the cooling device is mounted with a heat-generating element, and Fig. 11(b) is a side view of a cooling device using a heat transfer block, where the cooling device is mounted with a heat-generating element.
Fig. 12(a) is a front view of a cooling device using heat pipes according to another embodiment, where the cooling device is mounted with a heat-generating element, and Fig. 12(b) is a plan view of a cooling device using heat pipes according to another embodiment, where the cooling device is mounted with a heat-generating element.
Fig. 13 is a plan view of a cooling device according to another embodiment of the present invention, where the cooling device is mounted with a heat-generating element.
Fig. 14 is a side view of a cooling device of the conventional example, where the cooling device is mounted with a heat-generating element.

### [Description of the Preferred Embodiments]

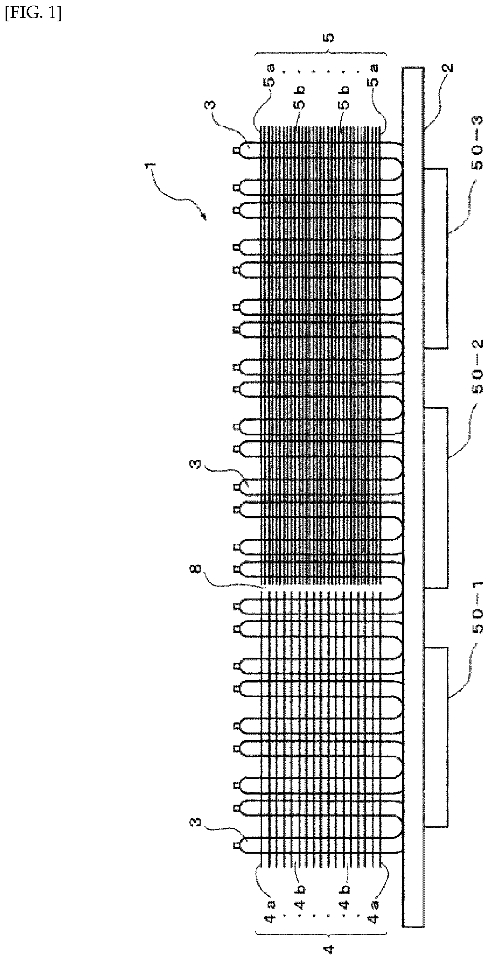

Hereinafter, a cooling device according to the first embodiment of the present invention is described with reference to the drawings. As shown in Fig. 1, the cooling device 1 according to the first embodiment of the present invention is a heat pipe-type cooling device including a flat plate-shaped heat-receiving block 2, a plurality of heat pipes 3 with a U-shape in side view mounted in the direction perpendicular to a surface of the heat-receiving block 2, a first heat radiation fin group 4, and a second heat radiation fin group 5. The first heat radiation fin group 4 and the second heat radiation fin group 5 are mounted on the heat pipes 3. The first heat radiation fin group 4 comprises a plurality (seventeen in Fig. 1) of first fins 4a. These first fins 4a are rectangular thin plates. The second heat radiation fin group 5 comprises a plurality (33 in Fig. 1) of second fins 5a. These second fins 5a are rectangular thin plates.

Further, heat-generating elements 50-1, 50-2, 50-3, which are objects to be cooled, are thermally connected to the back side of the heat-receiving block 2 on which the heat pipe 3 is not mounted. The heat-generating elements 50-1, 50-2, 50-3 are arranged in the direction from left to right in Fig. 1.

As shown in Fig. 1, the first heat radiation fin group 4 is arranged such that the seventeen first fins 4a are disposed at an equal interval in the direction perpendicular to a surface of the heat-receiving block 2. Further, all the first fins 4a are arranged in parallel with the surface of the heat-receiving block 2. Accordingly, in the first heat radiation fin group 4, sixteen gaps 4b with an equal width are extended between the first fins 4a in parallel with the surface of the heat-receiving block 2. All the gaps 4b in the first heat radiation fin group 4 have the same width.

Further, the second heat radiation fin group 5 is arranged such that 33 second fins 5a are disposed at an equal interval in the direction perpendicular to the surface of the heat-receiving block 2. Further, all the second fins 5a are arranged in parallel with the surface of the heat-receiving block 2. Accordingly, in the second heat radiation fin group 5, 32 gaps 5b with an equal width, which is smaller than the width of the gaps 4b, are extended between the second fins 5a in parallel with the surface of the heat-receiving block 2. All the gaps 5b in the second heat radiation fin group 5 have the same width.

Both the first fin 4a arranged at the furthest location from the heat-receiving block 2 and the second fin 5a arranged at the furthest location from the heat-receiving block 2 are arranged at the same level. Similarly, both the first fin 4a arranged at the nearest location to the heat-receiving block 2 and the second fin 5a arranged at the nearest location to the heat-receiving block 2 are arranged at the same level. The shapes and dimensions of the respective first fins 4a, which are constituent elements of the first heat radiation fin group 4, are the same as each other so that the edge portions of the first fins 4a are aligned at the side surface portions of the first heat radiation fin group 4. In addition, the shapes and dimensions of the second fins 5a, which are constituent elements of the second heat radiation fin group 5, are the same as each other so that the edge portions of the second fins 5a are aligned at the side surface portions of the second heat radiation fin group 5.

In the cooling device 1 according to the first embodiment, cooling air is supplied in the direction from left to right in Fig. 1. Further, the cooling device 1 is arranged so that cooling air is supplied in parallel or substantially in parallel with the surface of the heat-receiving block 2, i.e., supplied in parallel or substantially in parallel with the surfaces of each first fin 4a and each second fin 5a. In this way, the cooling air, first, travels through each first fin 4a in the first heat radiation fin group 4. Next, the cooling air having passed through the first heat radiation fin group 4 enters the second heat radiation fin group 5. In turn, the cooling air travels through each second fin 5a in the second heat radiation fin group 5. Therefore, it is possible to prevent the first heat radiation fin group 4 and the second heat radiation fin group 5 from blocking the cooling air. Further, a gap 8 between heat radiation fin groups is formed between the first heat radiation fin group 4 and the second heat radiation fin group 5. Due to this gap 8 between heat radiation fin groups, the fin 44a is not integrated as in the conventional example. Instead, the fin 44a is divided into the first fin 4a and the second fin 5a, thereby constituting the first heat radiation fin group 4 and the second heat radiation fin group 5.

In the cooling device 1 according to the first embodiment, the dimensions of the first fin 4a are 480 mm in width, 300 mm in length and 0.5 mm in thickness, and the width of the gaps 4b of the first fins 4a is 6.5 mm. Meanwhile, the width of the second fins 5a is 480 mm, as in the case of the first fins 4a. The thickness is 0.5 mm, as also in the case of the first fins 4a. However, for the reason to be described later, the length of the second fins 5a is 495 mm, which is longer than that of the first fins 4a. The width of the gaps 5b of the second fin is 3 mm. Also, the dimensions of the heat-receiving block 2 are 500 mm in width, 1000 mm in length and 25 mm in thickness. The dimensions of the heat pipe 3 with a U-shape in side view are 15.88 mm in pipe diameter, 200 mm in height and 115.88 mm in width. The cross-sectional shape of the pipes of the heat pipes 3 with a U-shape in side view is circular. The width of the gap 8 between heat radiation fin groups is preferably as small as possible in order not to adversely affect the cooling capacity. One end surface of the first fins 4a may be in contact with one end surface of the second fins 5a opposite to the aforementioned one end surface of the first fins 4a. In the cooling device 1 according to the first embodiment, the gap 8 between heat radiation fin groups is 5 mm in width.

Both the first fins 4a and the heat-receiving block 2 are flat plates made of highly heat conductive metal materials including aluminium, aluminium alloy, copper and copper alloy. The heat pipes 3 also are made of the same metal material as those of the first fins 4a and the heat-receiving block 2. As a working fluid, a working fluid compatible with a container material is filled in a pressure-reduced state. For example, pure water is used as the working fluid when the container is made of copper.

A method of securing the first fins 4a and the second fins 5a is not particularly limited. However, in the cooling device 1, openings (not shown) are formed at predetermined locations of both the first fins 4a and the second fin 5a. The heat pipes 3 are fittingly inserted and plugged into these openings so that the first fins 4a and the second fins 5a are secured to the cooling device 1 via the heat pipes 3.

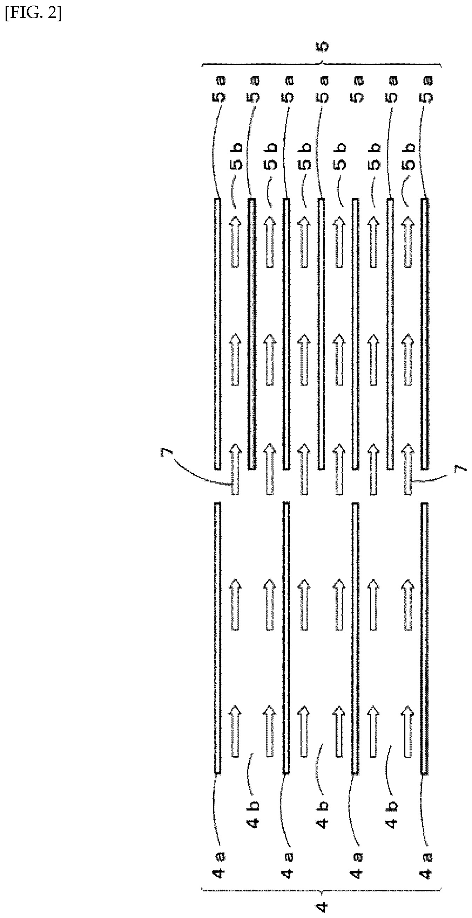

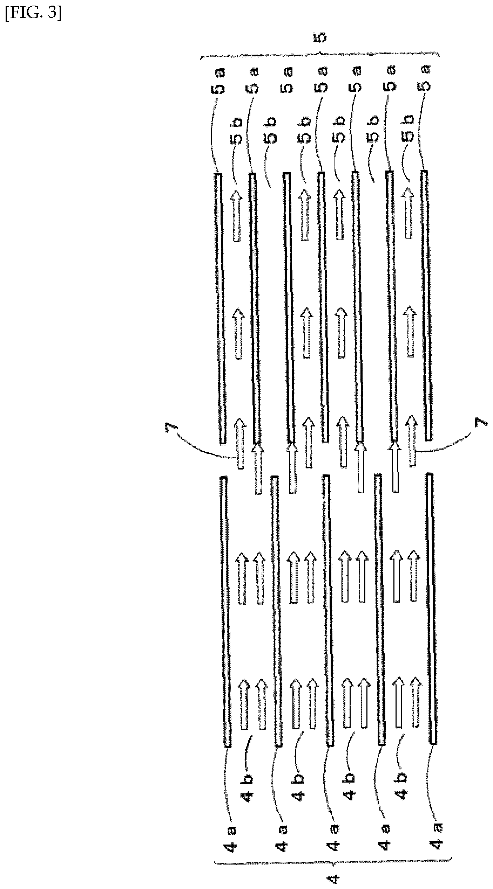

Next, the arrangement relationship between the first fins 4a and the second fins 5a of the cooling device 1 according to the first embodiment is described with reference to Figs. 2 and 3.

The arrangement relationship between the first fins 4a and the second fins 5a is not particularly limited as long as the gaps 4b between the first fins 4a are larger than the gaps 5b between the second fins 5a. The reason is that in the above embodiment, a reduction in the amount and velocity of the cooling air passing through the second heat radiation fin group 5 can be suppressed since the pressure loss by the first heat radiation fin group 4 can be reduced. Another reason is that by reducing the number of first fins 4a of the first heat radiation fin group 4, a temperature rise of the cooling air passing through the first heat radiation fin group 4 can be suppressed.

As shown in Fig. 2, in the cooling device 1 according to the first embodiment, the fin pitches of the first heat radiation fin group 4 and the second heat radiation fin group 5 are in an integer multiple relationship (in Fig. 2, the ratio of the fin pitch of the first heat radiation fin group 4 to that of the second heat radiation fin group 5 is 2:1). Further, the phases of the fin pitches of the first heat radiation fin group 4 and the second heat radiation fin group 5 are aligned. In other words, the second fins 5a of the second heat radiation fin group 5 are arranged at the same levels as the respective first fins 4a. Further, another second fin 5a is arranged at a portion corresponding to the center of the width of the gap 4b between the first fins 4a. This fin arrangement prevents the second fins 5a from blocking the cooling air 7, which has passed through the first heat radiation fin group 4 in the direction from left to right in the drawings. A loss of the amount and velocity of the cooling air 7 due to the pressure of the second fins 5a can be thereby suppressed. Accordingly, in the configuration of the cooling device 1 according to the first embodiment, the cooling air 7 having passed through the first heat radiation fin group 4 smoothly flows into the second heat radiation fin group 5 arranged on the leeward side.

Further, as shown in Fig. 3, for example, the fin pitches of the first heat radiation fin group 4 and the second heat radiation fin group 5 are not in an integer multiple relationship (in Fig. 3, the ratio of the fin pitch of the first heat radiation fin group 4 to that of the second heat radiation fin group 5 is 3:2). However, it is still possible to suppress a reduction in the amount and velocity of the cooling air 7 passing through the second heat radiation fin group 5. In this configuration, the phases of the fin pitches of the first heat radiation fin group 4 and the second heat radiation fin group 5 are not aligned. In other words, the first fin 4a that is aligned with the second fin 5a at the same level and the first fin 4a that is not aligned with the second fin 5a are alternating. Accordingly, in the fin arrangement of Fig. 3, the cooling air 7 flows smoothly in some portions of the second heat radiation group, and the cooling air 7 barely flows in other portions due to hindrance by the second fins.

Of the aforementioned arrangements of the first fins 4a and the second fins 5a, the arrangement of Fig. 2 is preferable as the fin pitches of the first heat radiation fin group 4 and the second heat radiation fin group 5 are in an integer multiple relationship in which the phases of the fin pitches are aligned. Specifically, the arrangement of Fig. 2 is preferable in preventing a loss of the amount and velocity of the cooling air 7 in the second heat radiation fin group 5, the loss that eventually arises from the pressure of the second fins 5a applied to the cooling air 7 having passed through the first heat radiation fin group 4.

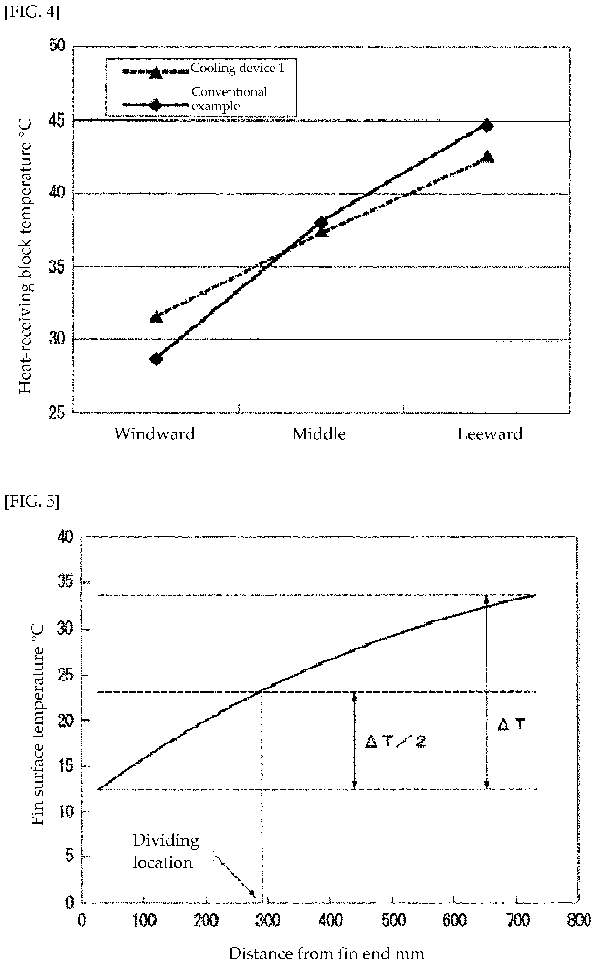

Next, the heat-receiving block temperature of the cooling device 1 according to the first embodiment and the heat-receiving block temperature of a cooling device 41 of the conventional example are described with reference to Fig. 4. The heat-receiving block temperatures were determined by numerical analysis. The configuration of the cooling device 1 according to the first embodiment used in the numerical analysis was the same as the aforementioned configuration. Meanwhile, the configuration of the cooling device 41 of the conventional example was the same as the configuration of the cooling device 1 used in the numerical analysis, except that the length of the fins 44a is a sum of the length of the first fins 4a, the length of the second fins 5a, and the width of the gap 8 between heat radiation fin groups and that the fin pitch of the heat radiation fin group 44 is the same as the fin pitch of the second heat radiation fin group 5. Heat was evenly generated from the respective heat-generating elements 50-1, 50-2, 50-3, 450-1, 450-2, 450-3, and a total amount of heat of 11000 W was input into both heat-receiving blocks 2, 42. Further, the numerical analyses were conducted under the conditions where the temperature and velocity of the cooling air that hits the front surfaces of the first heat radiation fin group 4 and the heat radiation fin group 44 are 20°C and 5.8 m/s, respectively.

As shown in Fig. 4, the temperature of the windward part of the heat-receiving block of the cooling device 1 is slightly increased to above that of the cooling device 41 of the conventional example. However, the temperature of the central part of the heat-receiving block is substantially equal to that of the conventional example, and the temperature of the leeward part of the heat-receiving block is lower than that of the conventional example. Therefore, the cooling device 1 of the first embodiment can reduce the total weight and increase the cooling capacity on the leeward side to make the cooling capacity uniform.

Next, a method of positioning the gap 8 between heat radiation fin groups of the cooling deice 1 according to the first embodiment is described with reference to Fig. 5. The line graph in Fig. 5 illustrates the temperature distribution on the surface of a fin 44a properly selected from the heat radiation fin group 44 of the cooling device 41 of the conventional example. In Fig. 5, the term "fin end" is defined as the end of a fin facing the windward of the cooling air. The location of the gap 8 between heat radiation fin groups, i.e., the ratio of the length of the first fins 4a to the length of the second fins 5a, is not particularly limited and can be selected properly. However, it is preferable to determine the ratio on the basis of the temperature distribution on the fin surface in order to increase the leeward cooling capacity, as described below.

As shown in Fig. 5, the surface temperature of the monolithic fin 44a of the conventional example increases as the cooling air travels from windward to leeward. The gap 8 between heat radiation fin groups is provided at a location where the temperature is the midpoint between the minimum and maximum temperatures of the surface of the fin 44a. In other words, the gap 8 between heat radiation fin groups is positioned in such a manner that the fin 44a is divided at a location of the temperature difference ΔT/2, where the temperature difference ΔT on the surface of the fin 44a is equally divided, so as to form the first heat radiation fin group 4 and the second heat radiation fin group 5. In this fashion, when the gap 8 between heat radiation fin groups is provided at a location exhibiting the midpoint temperature, two heat radiation fin groups are formed in regions where the surface temperature patterns of the fins are similar. Accordingly, when the fin pitch of the first heat radiation fin group 4 with a sufficient cooling capacity can be larger than that of the heat radiation fin group 44, it is possible to suppress a reduction in the amount and velocity of the cooling air passing through the second heat radiation fin group 5. Further, since the number of first fins 4a can be reduced, a temperature rise of the cooling air in the first heat radiation fin group 4 can be reduced so that the cooling air with a lower temperature can be supplied to the second heat radiation fin group 5. Further, since the number of first fins 4a can be reduced, it is possible to reduce the weight of the cooling device 1.

Further, as illustrated in the line graph of Fig. 5, the temperature distribution on the surface of the fin 44a shows that the temperature sharply falls toward the windward side. The relationship between the temperature distribution and the distance from the fin end is not linear. Accordingly, when the gap 8 between heat radiation fin groups is provided at a location of the temperature difference ΔT/2, where the temperature difference ΔT of the surface of the fin 44a can be divided equally, the length of the second fins 5a of the second heat radiation fin group 5 is longer than the length of the first fins 4a of the first heat radiation fin group 4.

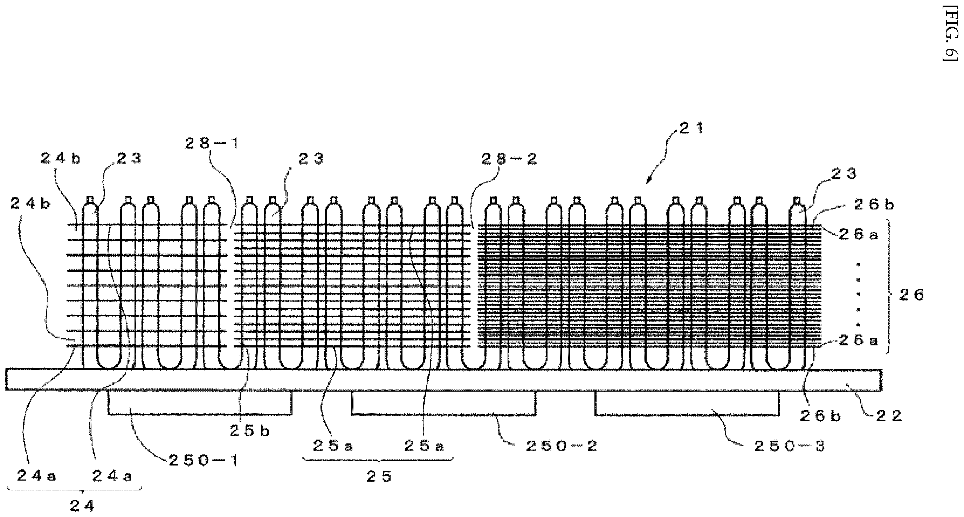

Next, a cooling device according to the third embodiment of the present invention is described with reference to the drawings. The cooling device 1 of the first embodiment includes two heat radiation fin groups. Instead, a cooling device 21 according to the third embodiment of the present invention includes three heat radiation fin groups, as shown in Fig. 6. The cooling device 21 according to the third embodiment includes a flat plate-shaped heat-receiving block 22, heat pipes 23 with a U-shape in side view mounted in the direction perpendicular to a surface of the heat-receiving block 22, a first heat radiation fin group 24, a second heat radiation fin group 25 and a third heat radiation fin group 26. The first heat radiation fin group 24, the second heat radiation fin group 25, and the third heat radiation fin group 26 are mounted on the heat pipes 23. The first heat radiation fin group 24 comprises a plurality (nine in Fig. 6) of first fins 24a. The second heat radiation fin group 25 comprises a plurality (seventeen in Fig. 6) of second fins 25a. The third heat radiation fin group 26 comprises a plurality (33 in Fig. 6) of third fins 26a. In other words, the number of second fins 25a of the cooling device 21 is the same as the number of first fins 4a of the cooling device 1, and the number of third fins 26a of the cooling device 21 is the same as the number of second fins 5a of the cooling device 1. The first fins 24a, the second fins 25a and the third fin 26a are all rectangular thin plates. A gap 28-1 between heat radiation fin groups is formed between the first heat radiation fin group 24 and the second heat radiation fin group 25, and a gap 28-2 between heat radiation fin groups is formed between the second heat radiation fin group 25 and the third heat radiation fin group 26.

Further, heat-generating elements, which are objects to be cooled, are disposed on the back side of the heat-receiving block 22, on which the heat pipes 23 are not mounted. These heat-generating elements are thermally connected to each other and assigned, in the order from windward to leeward, reference numerals 250-1, 250-2, 250-3.

The arrangement relationship between the first fins 24a, the second fins 25a and the third fins 26a is not particularly limited as long as the gaps 24b between the first fins 24a are larger than the gaps 25b between the second fins 25a and the gaps 25b between the second fins 25a are larger than the gaps 26b between the third fins 26a. In this embodiment, since the pressure loss due to the first heat radiation fin group 24 can be decreased, a reduction in the amount and velocity of the cooling air passing through the second heat radiation fin group 25 can be suppressed, and the number of first fins 24a is reduced so that a temperature rise of the cooling air having passed through the first heat radiation fin group 24 is suppressed. As the pressure loss due to the second heat radiation fin group 4 can be also decreased, a reduction in the amount and velocity of the cooling air passing through the third heat radiation fin group 26 can be suppressed, and the number of second fins 25a is reduced so that a temperature rise of the cooling air having passed through the second heat radiation fin group 25 is suppressed. As shown in Fig. 6, the cooling device 21 according to the third embodiment is arranged so that the fin pitches of the first heat radiation fin group 24 and the second heat radiation fin group 25 are in an integer multiple relationship. As well, the fin pitches of the second heat radiation fin group 25 and the third heat radiation fin group 26 are in an integer multiple relationship (in Fig. 6, the ratio of the fin pitch of the first heat radiation fin group 24 to the fin pitch of the second heat radiation fin group 25 to the fin pitch of the third heat radiation fin group 26 is 4:2:1). Further, the phases of the fin pitches of the first heat radiation fin group 24, the second heat radiation fin group 25 and the third heat radiation fin group 26 are aligned. In other words, the second fins 25a of the second heat radiation fin group 25 and the third fins 26a of the third heat radiation fin 26 group are arranged at the same level as that of the respective first fins 24a. As well, the second fins 25a are arranged at positions where the width of the gaps 24b between the first fins 24a are divided in half and the third fins 26a are arranged at positions where the width of the gaps 24b between the first fins 24a are divided in quarters.

In this way, as the fin arrangement is the same as that of the cooling device 1, the second fins 25a and the third fins 26a can be prevented from blocking the flow of the cooling air, and a loss of the amount and velocity of the cooling air due to the pressure of the second fins 25a and the third fins 26a can be suppressed. Accordingly, in this configuration, the cooling air passing through the first heat radiation fin group 24 smoothly flows into the second heat radiation fin group 25 arranged on the leeward side of the first heat radiation fin group 24 and the third heat radiation fin group 26 arranged on the leeward side of the second heat radiation fin group 25 so that the leeward cooling capacity is further increased.

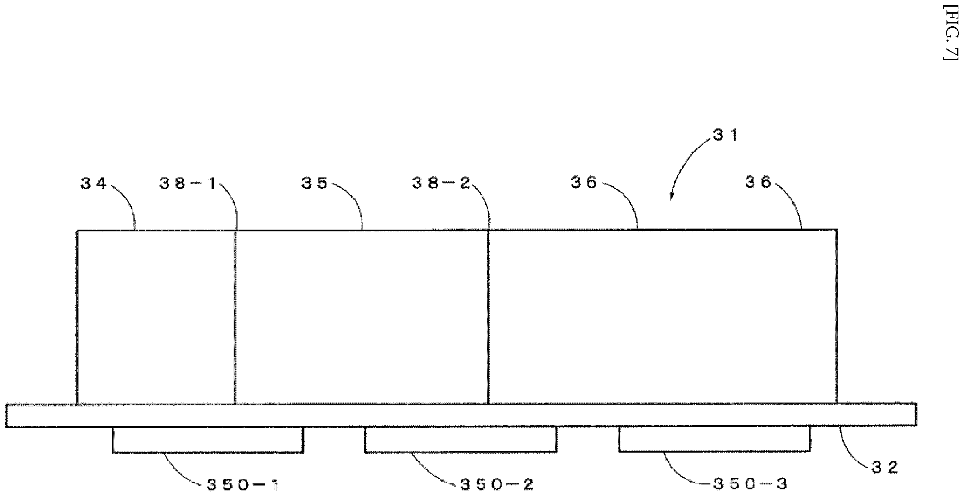

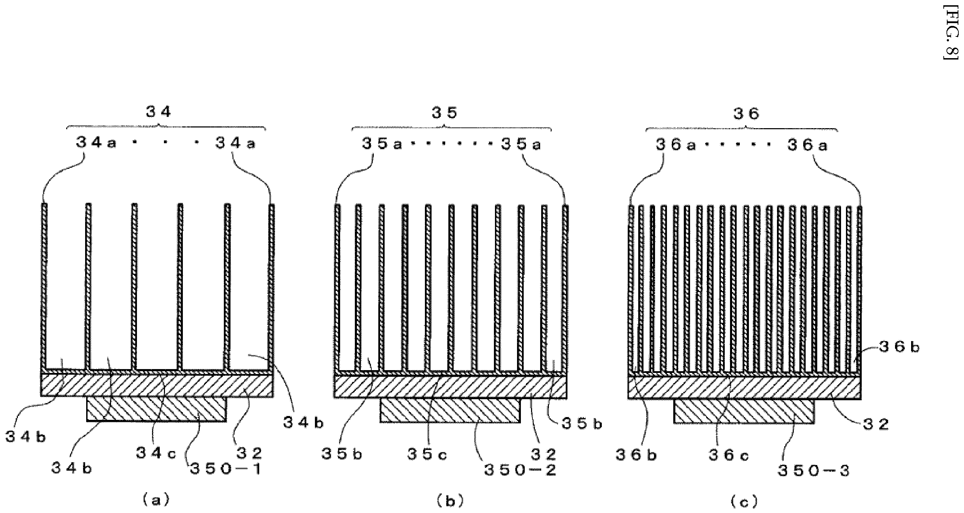

Next, a cooling device according to the second embodiment of the present invention is described with reference to the drawings. In the cooling device 1 of the first embodiment, the fins mounted on the heat pipes are erected in the direction perpendicular to the heat-receiving block so as to be in parallel with the heat-receiving block, and the aforementioned fins constitute the two heat radiation fin groups. Instead, a cooling device 31 according to the second embodiment of the present invention is a heat sink wherein a plurality of fins erected in the direction perpendicular to the heat-receiving block constitute three heat radiation fin groups, as shown in Figs. 7 and 8. The cooling device 31 according to the second embodiment includes a flat plate-shaped heat-receiving block 32, a first heat radiation fin group 34, a second heat radiation fin group 35 and a third heat radiation fin group 36. The first heat radiation fin group 34, the second heat radiation fin group 35, and the third heat radiation fin group 36 are mounted on a surface of the heat-receiving block 32.

As shown in Fig. 8(a), the first heat radiation fin group 34 is so structured that a plurality (six in Fig. 8(a)) of first fins 34a are erected on a flat plate-shaped bottom surface part 34c. Each first fin 34a is perpendicular to the bottom surface part 34c and so arranged that the surfaces of the first fins 34a are in parallel to the flow direction of the cooling air. The fin pitches thereof are at an equal interval. As shown in Fig. 8(b), the second heat radiation fin group 35 is so structured that a plurality (eleven in Fig. 8(b)) of second fins 35a are erected on a flat plate-shaped bottom surface part 35c. Every second fin 35a is perpendicular to the bottom surface part 35c and so arranged that the surfaces of the second fins 35a are in parallel to the flow direction of the cooling air. The fin pitches thereof are at an equal interval. As shown in Fig. 8(c), the third heat radiation fin group 36 is so structured that a plurality (21 in Fig. 8(c)) of third fins 36a are erected on a flat plate-shaped bottom surface part 36c. Each third fin 36a is perpendicular to the bottom surface part 36c and so arranged that the surfaces of the third fins 36a are in parallel to the flow direction of the cooling air. The fin pitches thereof are at an equal interval. When the bottom surface parts 34c, 35c, 36c are thermally connected to the heat-receiving block 32, the first heat radiation fin group 34, the second heat radiation fin group 35, and the third heat radiation fin group 36 are thermally connected to the heat-receiving block 32.

In the cooling device 31 according to the second embodiment, heat-generating elements, which are objects to be cooled, are disposed on the back side of the heat-receiving block 32, on which fins are not mounted. The heat-generating elements are thermally connected to each other and assigned, in the order from windward to leeward, reference numerals 350-1, 350-2, 350-3.

The arrangement relationship between the first fins 34a, the second fins 35a and the third fins 36a is not particularly limited as long as the gaps 34b between the first fins 34a are larger than the gaps 35b between the second fins 35a and the gaps 35b between the second fins 35a are larger than the gaps 36b between the third fins 36a. In this embodiment, a reduction in the amount and velocity of the cooling air passing through the second heat radiation fin group 35 and the third heat radiation fin group 36 can be suppressed. Also, the numbers of first fins 34 and second fins 35a are reduced so that a temperature rise of the cooling air having passed through the first heat radiation fin group 34 and the second heat radiation fin group 35 can be suppressed. As shown in Fig. 8, as in the case of the cooling device 21 of the third embodiment, the cooling device 31 according to the second embodiment is so arranged that the fin pitches of the first heat radiation fin group 34 and the second heat radiation fin group 35 are in an integer multiple relationship. As well, the fin pitches between the second heat radiation fin group 35 and the third heat radiation fin group 36 are in an integer multiple relationship (in Fig. 8, the ratio of the fin pitch of the first heat radiation fin group 34 to the fin pitch of the second heat radiation fin group 35 to the fin pitch of the third heat radiation fin group 36 is 4:2:1). Further, the phases of the fin pitches of the first heat radiation fin group 34, the second heat radiation fin group 35 and the third heat radiation fin group 36 are aligned. In other words, the second fins 35a of the second heat radiation fin group 35 and the third fins 36a of the third heat radiation fin 36 group are arranged at the same level as that of the respective first fins 24a. In addition, the second fins 35a are arranged at positions where the width of the gaps 34b between the first fins 34a are divided in half, and the third fins 36a are arranged at positions where the width of the gaps 34b between the first fins 34a are divided in quarters.

In this way, the fin arrangement is the same as that of the cooling device 21. In this configuration, the cooling air having passed through the first heat radiation fin group 34 smoothly flows into the second heat radiation fin group 35 arranged on the leeward side of the first heat radiation fin group 34 and the third heat radiation fin group 36 arranged on the leeward side of the second heat radiation fin group 35.

In the cooling device 31 according to the aforementioned second embodiment, in order to prevent a reduction in the amount and velocity of the cooling air and a turbulent flow of the cooling air, the first heat radiation fin group 34 and the second heat radiation fin group 35 are brought into contact with each other to form a heat radiation fin group boundary part 38-1. Also, the second heat radiation fin group 35 and the third heat radiation fin group 36 are brought into contact with each other to form a heat radiation fin group boundary part 38-2. If necessary, as in the case of the cooling device 21 of the third embodiment, the adjacent heat radiation fin groups may be properly separated so that gaps between heat radiation fin groups are formed as the heat radiation fin group boundary parts 38-1, 38-2.

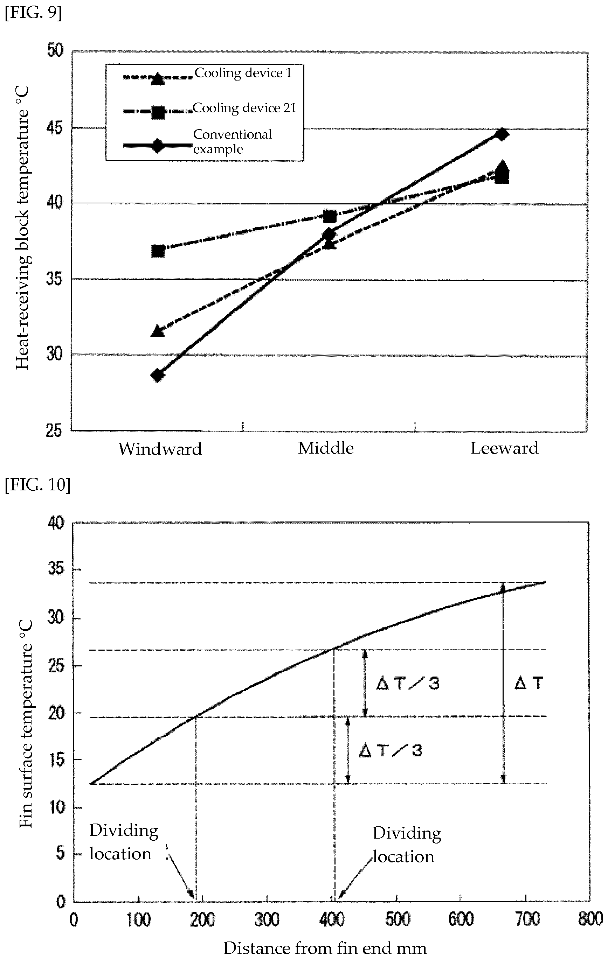

Next, the heat-receiving block temperature of the cooling device 21 according to the third embodiment and the heat-receiving block temperature of the cooling device 41 of the conventional example are described with reference to Fig. 9. The temperatures of the heat-receiving blocks were determined by numerical analysis under the same conditions as in Fig. 4. In other words, the configuration of the cooling device 21 according to the third embodiment used in the numerical analysis was the same as the aforementioned configuration. The configuration of the cooling device 41 of the conventional example was the same as the configuration of the cooling device 21 used in the numerical analysis, except that the length of the fins 44a is a sum of the length of the first fins 24a, the length of the second fins 25a, the length of the third fins 26a, and the widths of the gaps 28-1, 28-2 between heat radiation fin groups and that the fin pitch of the heat radiation fin group 44 is the same as that of the third heat radiation fin group 26. Heat was evenly generated from the respective heat-generating elements 250-1, 250-2, 250-3, 450-1, 450-2, 450-3, and a total amount of heat of 11000 W was input into both heat-receiving blocks 22, 42. Further, the numerical analyses were conducted under the conditions where the temperature and velocity of the cooling air that hits front surfaces of the first heat radiation fin group 24 and the heat radiation fin group 44 were 20°C and 5.8 m/s, respectively. Fig. 9 illustrates also, for comparison, the data of the cooling device 1 shown in Fig. 4.

As shown in Fig. 9, the temperature of the windward part of the heat-receiving block of the cooling device 21 is increased to above that of the cooling device 41 of the conventional example. However, the temperature of the central part of the heat-receiving block is almost equal to that of the conventional example, and the temperature of the leeward part of the heat-receiving block is lower than that of the conventional example. Further, in the cooling device 21 of the third embodiment, the temperature of the leeward part of the heat-receiving block is lower than that of the cooling device 1 of the first embodiment. Therefore, in the cooling device 21 of the third embodiment, the number of heat radiation fin groups with different fin pitches is increased to three so that the leeward cooling capacity is further increased compared with the cooling device 1. In this way, the cooling capacity can be made uniform and the total weight can be further reduced.

Next, a method of positioning the gaps 28-1, 28-2 between heat radiation fin groups of the cooling device 21 according to the third embodiment and a method of positioning the heat radiation fin group boundary parts 38-1, 38-2 of the cooling device 31 according to the second embodiment are described, with reference to Fig. 10. The line graph in Fig. 10 is the temperature distribution on the surface of a fin 44a properly selected from the heat radiation fin group 44 of the cooling device 41 of the conventional example. In Fig. 10, the term "fin end" is defined as the end of a fin facing the windward of the cooling air.

The locations of the gaps 28-1, 28-2 between heat radiation fin groups and the locations of the heat radiation fin group boundary parts 38-1, 38-2 are not particularly limited and can be properly selected. However, it is preferable to make the aforementioned selection on the basis of the temperature distribution on the fin surface in order to increase the leeward cooling capacity, as in the case of the cooling device 1 of the first embodiment. In other words, the gaps 28-1, 28-2 between heat radiation fin groups or the heat radiation fin group boundary parts 38-1, 38-2 are positioned in such a manner that the fin 44a is divided at the locations of the temperature differences ΔT/3, where the temperature difference ΔT of the surface of the monolithic fin 44a according to the conventional example is equally divided into thirds, so as to form the first heat radiation fin group 24, 34, the second heat radiation fin group 25, 35, and the third heat radiation fin group 26, 36. In this fashion, when the gaps 28-1, 28-2 between heat radiation fin groups or the heat radiation fin group boundary parts 38-1, 38-2 are provided at locations exhibiting the temperature differences ΔT/3, three heat radiation fin groups can be formed in regions where the surface temperature patterns of the fins are similar. Accordingly, the fin pitches of the first heat radiation fin group 24, 34 and the second heat radiation fin group 25, 35 with a sufficient cooling capacity can be larger than the fin pitch of the heat radiation fin group 44. Also, the fin pitch of the first heat radiation fin group 24, 34 can be larger than the fin pitch of the first heat radiation fin group 4 of the cooling device 1. It is thereby possible to further suppress reduction in the amount and velocity of the cooling air passing through the third heat radiation fin group 26, 36. Further, since the velocity of the cooling air passing through the first heat radiation fin group 24, 34 is large, it is possible to further suppress a temperature rise of the cooling air in the first heat radiation fin group 24, 34 so that the cooling air with a temperature lower than that of the cooling device 1 can be supplied to the second heat radiation fin group 25, 35 and the third heat radiation fin group 26, 36. Further, since the number of first fins 24a, 34a can be decreased, the weight of the cooling device 21, 31 can be further reduced.

At this time, for the same reason as for the cooling device 1 of the first embodiment, the gaps 28-1, 28-2 between heat radiation fin groups or the heat radiation fin group boundary parts 38-1, 38-2 can be provided at locations of the temperature differences ΔT/3, where the temperature difference ΔT of the surface of the fin 44a can be equally divided into thirds. In this setting, the length of the second fins 25a, 35a of the second heat radiation fin group 25, 35 is longer than the length of the first fins 24a, 34a of the first heat radiation fin group 24, 34. Also, the length of the third fins 26a, 36a of the third heat radiation fin group 26, 36 is longer than the length of the second fins 25a, 35a of the second heat radiation fin group 25, 35.

Next, a use method of the cooling device of the present invention is described. Herein described is an example of a method of using the cooling device 1, 21, 31 according to the above embodiments of the present invention to cool electronic components (e.g., power conversion devices) mounted on transportation means (e.g., railroad vehicles). The housing for power control shielded from the outside is secured to the underfloor surface of a railroad vehicle, and various electronic components for power control, e.g., power conversion devices, are stored in the housing. These electronic components generate heat during operation. When the heat generation is not under control, the temperature rises and the normal operation is rendered impossible. In the worst case, the elements can be broken by heat. Therefore, these electronic component need to be cooled.

The electronic component (hereinafter referred to as the heat-generating element) is brought into contact with the back side of the heat-receiving block 2, 22, 32 of the cooling device 1, 21, 31 so as to be thermally connected to the heat-receiving block 2, 22, 32. A fan for supplying cooling air to the cooling device 1, 21, 31 is installed in the housing in which the heat-generating element has been stored. The cooling device 1, 21, 31 is arranged in such a manner that the first heat radiation fin group 4, 24, 34 with a larger fin pitch is oriented to face the windward of the cooling air. Also, in this arrangement, the cooling air from the fan travels in the order from the first heat radiation fin group 4, 24, 34 to the second heat radiation fin group 5, 25, 35 with a smaller fin pitch. In the case of the cooling device 21, 31, the cooling air is destined to the third heat radiation fin group 26, 36 with the smallest fin pitch. In other words, the flow direction of the cooling air supplied from the fan is in parallel to a surface of the heat-receiving block 2, 22, 32.

In the case of the cooling device 1, 21, the heat released from the heat-generating element is first conducted to the heat-receiving block 2, 22, which is thermally connected to the heat-generating element. The heat conducted to the heat-receiving block 2, 22 is transferred to the bottom part of the heat pipes 3, 23 embedded in the heat-receiving block 2, 22, i.e., a heating portion. Then, a heat transport system of the heat pipes 3, 23 is activated, and the heat absorbed by the heating portion is transferred, via a cooling portion of the heat pipes 3, 23 extending from the heating portion, to the heat radiation fin groups subjected to the flow of the cooling air supplied from the fan, and then the heat is discharged from the heat radiation fin groups to the outside. Meanwhile, in the case of the cooling device 31 without heat pipes, the heat released from the heat-generating element is conducted to the heat-receiving block 32, which is thermally connected to the heat-generating element. The heat conducted to the heat-receiving block 32 is transferred to the heat radiation fin groups subjected to the flow of the cooling air supplied from the fan, and then the heat is discharged from the heat radiation fin groups to the outside.

As the fin pitches of the heat radiation fin groups decreases in the order from the windward to the leeward of the cooling air, the leeward cooling capacity is increased by suppressing a reduction in the amount and velocity of the cooling air passing through the windward heat radiation fin group. Therefore, even if, for example, the cooling device is increased in size to cool the power conversion device of a railroad vehicle, the heat-generating portion far from the windward can be cooled without fail. In the above example of a use method, the cooling air is supplied from the fan. However, when the cooling device 1, 21, 31 is placed outside the housing, wind generated by travel of the vehicle may be used as cooling air, in place of installation of a fan.

Next, an example of a manufacturing method of a cooling device of the present invention is described. In the cooling device 1 of the first embodiment and the cooling device 21 of the third embodiment, first, the bottom parts of the heat pipes 3, 23 with a U-shape in side view are embedded under the surface of the heat-receiving block 2, 22 so that a plurality of heat pipes 3, 23 are arranged on and secured to the heat-receiving blocks 2, 22. The fins 4a, 5a, 24a, 25a, 26a are provided with openings (not shown) with shapes corresponding to the cross-sectional shapes of the pipes of the heat pipes 3, 23. The locations of the openings correspond to the locations where the heat pipes 3, 23 are arranged. Therefore, next, of the heat pipes 3, 23 secured to the heat-receiving block 2, 22, a predetermined heat pipe 3, 23 located on the windward is fitted into an opening of the first fin 4a, 24a to manufacture the first heat radiation fin group 4, 24 with a predetermined number of first fins 4a, 24a. Then, the predetermined heat pipe 3, 23 located on the leeward thereof is fitted into an opening of the second fin 5a, 25a to manufacture the second heat radiation fin group 5, 25 with a predetermined number of second fins 5a, 25a. In the case of the cooling device 21, the predetermined heat pipe 23 located on the leeward is further fitted into an opening of the third fin 26a to manufacture the third heat radiation fin group 26 with a predetermined number of third fins 26a. In this way, the fins 4a, 5a, 24a, 25a, 26a are mounted on the heat pipes 3, 23, which are secured to the heat-receiving block 2, 22, so as to manufacture the cooling device of the present invention.

For the cooling device 31 of the second embodiment, the first heat radiation fin group 34 shown in Fig. 8(a), the second heat radiation fin group 35 in Fig. 8(b) and the third heat radiation fin group 36 in Fig. 8(c) are each manufactured by extrusion molding using a die. Then, the respective heat radiation fin groups are secured to the surface of the heat-receiving block 32 in the order from the windward side of the cooling air to the leeward side thereof. Specifically, the aforementioned securing was made in the order of: the first heat radiation fin group 34, the second heat radiation fin group 35, and the third heat radiation fin group 36. The securing means may be commonly-used means including, for example, a means of fastening the bottom surface parts 34c, 35c, 36c to the surface of the heat-receiving block 32 by a screw.

Next, an example of another embodiment of the present invention is described. In the aforementioned respective embodiments, two to three heat radiation fin groups are installed, but four or more may be installed in this embodiment, depending on the cooling condition, etc. In the aforementioned respective embodiments, the fins of the heat radiation fin group are installed at an equal interval, but the intervals of the fins may be varied properly in this embodiment. In an embodiment where the gap between the fins of the windward heat radiation fin group is larger than the gap between the fins of the leeward heat radiation fin group, the effect of increasing the leeward cooling capacity is provided even when the intervals of the fins are not equal. In the aforementioned respective embodiments, the heat pipes with a U-shape in side view are used, but instead, heat pipes with an L-shape in side view or the like may be used in this embodiment.

Further, in the above first and the third embodiments, the heat pipes are erected in the direction perpendicular to the surface of the heat-receiving block. Instead, the heat pipes may be properly inclined with respect to the surface of the heat-receiving block. For instance, as disclosed in Patent Document 1, when the heat-receiving block is installed vertically, the heat pipes may be inclined to a predetermined angle (e.g., 5 to 10 degrees) with respect to the direction perpendicular to the surface of the heat-receiving block so that the cooling portion for the heat pipes is situated above the heating portion. In this way, by inclining the heat pipes to a predetermined angle, a reduction in the amount of heat transported by the heat pipes can be prevented.

Further, in the above first and third embodiments, the heat pipes are erected on the heat-receiving block. Instead, the cooling device 11 may be provided such that the heat transfer blocks are erected on the heat-receiving block, as shown in Figs. 11(a) and 11(b). In other words, on the heat-receiving block 12 of the cooling device 11, a plurality of column-shaped (e.g., cylindrical) heat transfer blocks 13 made of a highly heat conductive metal material (e.g., aluminium) are erected on the surface of the heat-receiving block 12 in the direction perpendicular to the surface of the heat-receiving block 12. A plurality of first fins 14a are mounted on the heat transfer blocks 13 at predetermined locations in the direction parallel to the surface of the heat-receiving block 12 so as to form the first heat radiation fin group 14. Further, a plurality of second fins 15a are mounted on the heat transfer block 13 at predetermined locations in the direction parallel to the surface of the heat-receiving block 12 so as to form the second heat radiation fin group 15. In this embodiment, heat is released from the heat-generating elements 150-1, 150-2, 150-3 and absorbed by the heat-receiving block 12. Then the heat is transferred via the heat transfer block 13 to the first fins 14a and the second fins 15a and discharged from the first fins 14a and the second fins 15a to the outside. In this manner, the cooling capacity is increased by using a column-shaped metal material with excellent heat conductivity, instead of the heat pipes.

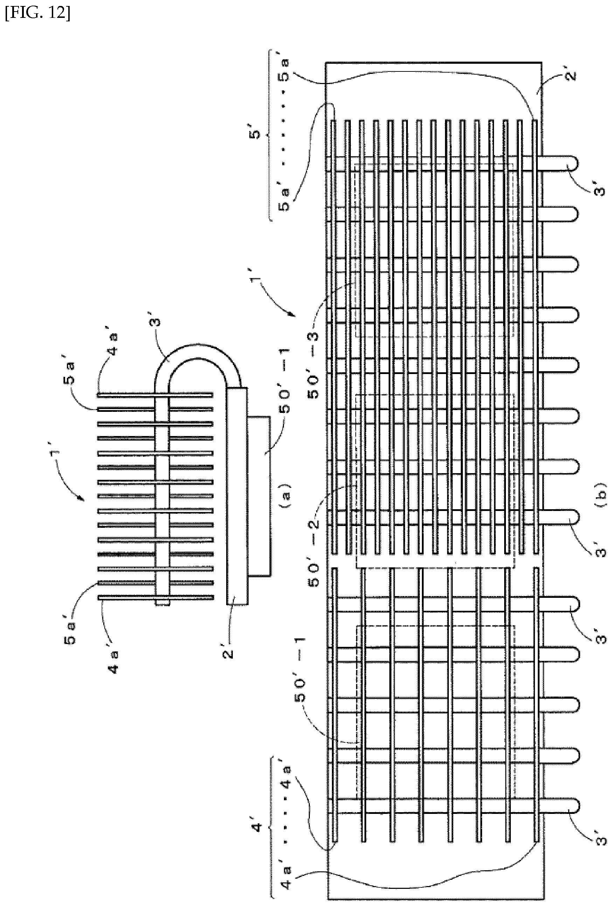

Further, in the above first and third embodiments, the heat pipes are erected in the direction perpendicular to the surface of the heat-receiving block. Instead, the heat pipes may be mounted on a side surface of the heat-receiving block, as shown in Figs. 12(a) and 12(b). In other words, in the cooling device 1', a plurality of heat pipes 3' with a J-shape in front view are arranged on a side surface of the heat-receiving block 2'. The plurality of heat pipes 3' include a curved part outwardly extending from the side surface and a straight part extending from the curved part over the surface of the heat-receiving block 2' in the direction parallel to the surface of the heat-receiving block 2'. A plurality of first fins 4a' are mounted on the heat pipes 3' at predetermined locations in the direction perpendicular to the surface of the heat-receiving block 2' to form the first heat radiation fin group 4'. Further, a plurality of second fins 5a' are mounted on the heat pipes 3' at predetermined locations in the direction perpendicular to the surface of the heat-receiving block 2' to form the second heat radiation fin group 5'. In this embodiment, heat is released from the heat-generating elements 50'-1, 50'-2, 50'-3 and absorbed by the heat-receiving block 2'. Then the heat is transferred via the heat pipes 3' to the first fins 4a' and the second fins 5a' and discharged from the first fins 4a' and the second fins 5a' to the outside. Further, in the above cooling device 1', as shown in Fig. 12(a), neither the first fins 4a' nor the second fins 5a' are in contact with the surface of the heat-receiving block 2'. Instead of the foregoing embodiment, the first fins 4a' and the second fins 5a' may be, in whole or in part, brought into contact with the surface of the heat-receiving block 2'. When the first fins 4a' and the second fins 5a' are in contact with the surface of the heat-receiving block 2', the heat is transferred via the heat pipes 3' to the first fins 4a' and the second fins 5a' and further transferred directly from the heat-receiving block 2' to the first fins 4a' and the second fins 5a'.

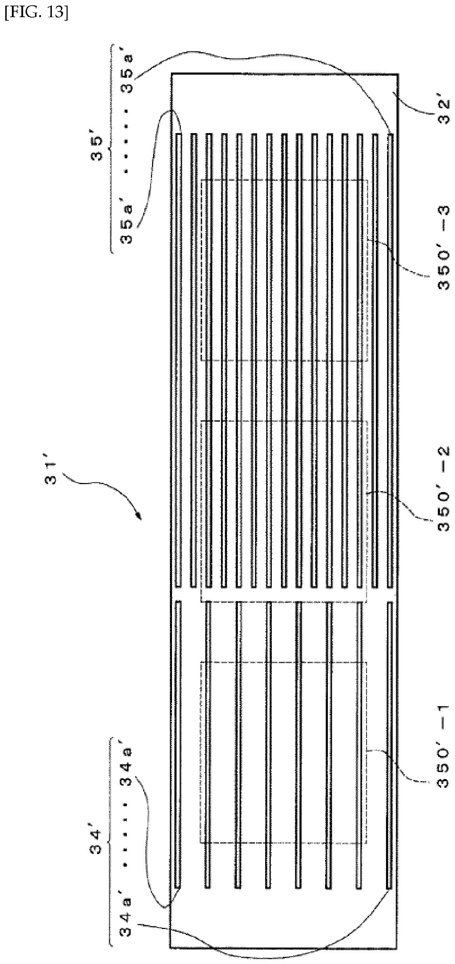

Further, in the second embodiment, the respective heat radiation fin groups are so structured that a plurality of fins are erected on the flat plate-shaped bottom surface part and this bottom surface part is in direct contact with the heat-receiving block. Instead, as shown in Fig. 13, the cooling device 31' may be provided such that the fins are erected directly on the surface of the heat-receiving block so that the fins are thermally connected to the heat-receiving block. In other words, in the cooling device 31', the first fins 34a' of the first heat radiation fin group 34' and the second fin 35a' of the second heat radiation fin group 35' are arranged directly on the surface of the heat-receiving block 32'. The method of securing the first fins 34a' and the second fins 35a' to the heat-receiving block 32' is not particularly limited. Examples of the securing method include a method comprising the steps of: forming grooves for fitting the first fins 34a' and the second fins 35a' on the surface of the heat-receiving block 32'; fitting the first fins 34a' and the second fins 35a' into these grooves; and pressing the surface of the heat-receiving block 32' on either side of each fin by a pressing jig and performing swaging for fixation. In this embodiment, heat is released from the heat-generating elements 350'-1, 350'-2, 350'-3 and absorbed by the heat-receiving block 32'. Then the heat is transferred to the first fins 34a' and the second fins 35a', which are in direct contact with the heat-receiving block 32', and discharged from the first fins 34a' and the second fins 35a' to the outside.

### [Industrial Applicability]

Since a pressure loss of the cooling air due to the windward heat radiation fin group is suppressed and the leeward cooling capacity is increased, the cooling capacity across the heat-receiving block can be made uniform. Therefore, the utility value is high in the field of large-scale cooling devices, e.g., cooling devices that performs forced-air cooling for heat-generating objects including power conversion devices mounted on railroad vehicles.

### [Description of Reference Numerals]

- 1, 11, 21, 31: cooling device
- 1', 31': cooling device
- 2, 12, 22, 32: heat-receiving block
- 2', 32': heat-receiving block
- 3, 23: heat pipe
- 3': heat pipe
- 4, 14, 24, 34: first heat radiation fin group
- 4', 34': first heat radiation fin group
- 4a, 14a, 24a, 34a: first fin
- 4a', 34a': first fin
- 5, 15, 25, 35: second heat radiation fin group
- 5', 35': second heat radiation fin group
- 5a, 25a, 35a: second fin
- 5a', 35a': second fin
- 26, 36: third heat radiation fin group
- 26a, 36a: third fin

## Claims

1. A cooling device (1, 11, 21, 31), comprising:
a heat-receiving block (2, 12, 22, 32) thermally connected to a heat-generating element (50-1, 50-2, 50-3; 150-1, 150-2, 150-3; 250-1, 250-2, 250-3; 350-1, 350-2, 350-3); and
heat radiation fin groups (4, 14, 24, 34; 5, 15, 25, 35; 26, 36) having a plurality of fins (4a, 5a, 6a) thermally connected to the heat-receiving block (2, 12, 22, 32),
wherein
a flow of cooling air is set in a direction parallel to the heat-receiving block (2, 12, 22, 32),
the plurality of heat radiation fin groups (4, 14, 24, 34; 5, 15, 25, 35; 26, 36) are arranged in tandem along the flow direction of the cooling air, and
of the plurality of heat radiation fin groups (4, 14, 24, 34), a fin pitch of a heat radiation fin group (4, 14, 24, 34) arranged on a windward side of the cooling air is larger than a fin pitch of a heat radiation fin group (5, 15, 25, 35) arranged on a leeward side of the cooling air,
**characterized in that**
when regarding the plurality of heat radiation fin groups (4, 14, 24, 34; 5, 15, 25, 35; 26, 36) as a single group (44) of heat radiation fins (44a) formed of a plurality of fins (44a), the position of a gap (8, 18; 28-1, 28-2; 38-1, 38-2) between the heat radiation fin groups (4, 14, 24, 34; 5, 15, 25, 35; 26, 36) corresponds to the position of the surface temperature of the single group (44) of heat radiation fins (44a) that equally divides the temperature difference on the surface of the single group (44) of heat radiation fins (44a) between windward and leeward by the number of heat radiation fin groups (4, 14, 24, 34; 5, 15, 25, 35; 26, 36).

2. A cooling device (31), comprising:
a heat-receiving block (32) thermally connected to a heat-generating element (350-1, 350-2, 350-3); and
heat radiation fin groups (34, 35, 36) having a plurality of fins (34a, 35a, 36a) erected on a surface of the heat-receiving block (32),
wherein
a flow of cooling air is set in a direction parallel to the heat-receiving block (32),
the plurality of heat radiation fin groups (34, 35, 36) are arranged in tandem along the flow direction of the cooling air, and
of the plurality of heat radiation fin groups (34, 35, 36), a fin pitch of a heat radiation fin group (34) arranged on a windward side of the cooling air is larger than a fin pitch of a heat radiation fin group (35) arranged on a leeward side of the cooling air,
**characterized in that**
when regarding the plurality of heat radiation fin groups (34, 35, 36) as a single group (44) of heat radiation fins (44a) formed of a plurality of fins (44a), the position of a gap (38-1, 38-2) between the heat radiation fin groups (34, 35, 36) corresponds to the position of the surface temperature of the single group (44) of heat radiation fins (44a) that equally divides the temperature difference on the surface of the single group (44) of heat radiation fins (44a) between windward and leeward by the number of heat radiation fin groups (34, 35, 36).

3. A cooling device (1, 21), comprising:
a heat-receiving block (2, 22) thermally connected to a heat-generating element;
a plurality of heat pipes (3, 23) erected on a surface of the heat-receiving block (2, 22); and
heat radiation fin groups (4, 5; 24, 25, 26) having a plurality of fins (4a, 5a; 24a, 25a, 26a) mounted on the heat pipes,
wherein
a flow of cooling air is set in a direction parallel to the heat-receiving block (2, 22),
the plurality of heat radiation fin groups (4, 5; 24, 25, 26) are arranged in tandem along the flow direction of the cooling air, and
of the plurality of heat radiation fin groups (4, 5; 24, 25, 26), a fin pitch of a heat radiation fin group (4; 24) arranged on a windward side of the cooling air is larger than a fin pitch of a heat radiation fin group (5; 25) arranged on a leeward side of the cooling air,
**characterized in that**
when regarding the plurality of heat radiation fin groups (4, 5; 24, 25, 26) as a single group (44) of heat radiation fins (44a) formed of a plurality of fins (44a), the position of a gap (8; 28-1, 28-2) between the heat radiation fin groups (4, 5; 24, 25, 26) corresponds to the position of the surface temperature of the single group (44) of heat radiation fins (44a) that equally divides the temperature difference on the surface of the single group (44) of heat radiation fins (44a) between windward and leeward by the number of heat radiation fin groups (4, 5; 24, 25, 26).

4. The cooling device (1, 11, 21, 31) according to any one of claims 1 to 3, wherein the fin pitch of the heat radiation fin group (4, 14, 24, 34) arranged on the windward side is an integer multiple of the fin pitch of the heat radiation fin group (5, 15, 25, 35) arranged on the leeward side.

5. The cooling device (1, 11, 21, 31) according to any one of claims 1 to 3, wherein a length of the fins (4a, 14a, 24a, 34a) of the heat radiation fin group (4, 14, 24, 34) arranged on the windward side is shorter than a length of the fins (5a, 15a, 25a, 35a) of the heat radiation fin group arranged on the leeward side (5, 15, 25, 35).

6. The cooling device (1, 21) according to claim 3, wherein the heat pipes (3, 23) are U-shaped or L-shaped in side view.

## Patentansprüche

1. Kühlvorrichtung (1, 11, 21, 31), Folgendes aufweisend:
einen Wärmeaufnahmeblock (2, 12, 22, 32), der thermisch an ein Wärmeerzeugungselement (50-1, 50-2, 50-3; 150-1, 150-2, 150-3; 250-1, 250-2, 250-3; 350-1, 350-2, 350-3) angeschlossen ist; und
Wärmeabstrahlungsrippengruppen (4, 14, 24, 34; 5, 15, 25, 35; 26, 36) mit mehreren Rippen (4a, 5a, 6a), die thermisch an den Wärmeaufnahmeblock (2, 12, 22, 32) angeschlossen sind,
wobei
eine Kühlluftströmung in einer zum Wärmeaufnahmeblock (2, 12, 22, 32) parallelen Richtung hergestellt wird,
die mehreren Wärmeabstrahlungsrippengruppen (4, 14, 24, 34; 5, 15, 25, 35; 26, 36) entlang der Strömungsrichtung der Kühlluft hintereinandergeschaltet sind, und
von den mehreren Wärmeabstrahlungsrippengruppen (4, 14, 24, 34) eine Rippenteilung einer Wärmeabstrahlungsrippengruppe (4, 14, 24, 34), die auf einer Anströmseite der Kühlluft angeordnet ist, größer ist als eine Rippenteilung einer Wärmeabstrahlungsrippengruppe (5, 15, 25, 35), die auf einer Abströmseite der Kühlluft angeordnet ist,
**dadurch gekennzeichnet, dass**
bei Betrachtung der mehreren Wärmeabstrahlungsrippengruppen (4, 14, 24, 34; 5, 15, 25, 35; 26, 36) als eine einzelne Gruppe (44) von Wärmeabstrahlungsrippen (44a), die aus mehreren Rippen (44a) besteht, die Position eines Zwischenraums (8, 18; 28-1, 28-2; 38-1, 38-2) zwischen den Wärmeabstrahlungsrippengruppen (4, 14, 24, 34; 5, 15, 25, 35; 26, 36) der Position der Oberflächentemperatur der einzelnen Gruppe (44) von Wärmeabstrahlungsrippen (44a) entspricht, welche den Temperaturunterschied auf der Oberfläche der einzelnen Gruppe (44) von Wärmeabstrahlungsrippen (44a) zwischen An- und Abströmung durch die Anzahl an Wärmeabstrahlungsrippengruppen (4, 14, 24, 34; 5, 15, 25, 35; 26, 36) gleich unterteilt.

2. Kühlvorrichtung (31), Folgendes aufweisend:
einen Wärmeaufnahmeblock (32), der thermisch an ein Wärmeerzeugungselement (350-1, 350-2, 350-3) angeschlossen ist; und
Wärmeabstrahlungsrippengruppen (34, 35, 36) mit mehreren Rippen (34a, 35a, 36a), die auf einer Oberfläche des Wärmeaufnahmeblocks (32) aufgerichtet sind,
wobei
eine Kühlluftströmung in einer zum Wärmeaufnahmeblock (32) parallelen Richtung hergestellt wird,
die mehreren Wärmeabstrahlungsrippengruppen (34, 35, 36) entlang der Strömungsrichtung der Kühlluft hintereinandergeschaltet sind, und
von den mehreren Wärmeabstrahlungsrippengruppen (34, 35, 36) eine Rippenteilung einer Wärmeabstrahlungsrippengruppe (34), die auf einer Anströmseite der Kühlluft angeordnet ist, größer ist als eine Rippenteilung einer Wärmeabstrahlungsrippengruppe (35), die auf einer Abströmseite der Kühlluft angeordnet ist,
**dadurch gekennzeichnet, dass**
bei Betrachtung der mehreren Wärmeabstrahlungsrippengruppen (34, 35, 36) als eine einzelne Gruppe (44) von Wärmeabstrahlungsrippen (44a), die aus mehreren Rippen (44a) besteht, die Position eines Zwischenraums (38-1, 38-2) zwischen den Wärmeabstrahlungsrippengruppen (34, 35, 36) der Position der Oberflächentemperatur der einzelnen Gruppe (44) von Wärmeabstrahlungsrippen (44a) entspricht, welche den Temperaturunterschied auf der Oberfläche der einzelnen Gruppe (44) von Wärmeabstrahlungsrippen (44a) zwischen An- und Abströmung durch die Anzahl an Wärmeabstrahlungsrippengruppen (34, 35, 36) gleich unterteilt.

3. Kühlvorrichtung (1, 21), Folgendes aufweisend:
einen Wärmeaufnahmeblock (2, 22), der thermisch an ein Wärmeerzeugungselement angeschlossen ist;
mehrere Wärmerohre (3, 23), die auf einer Oberfläche des Wärmeaufnahmeblocks (2, 22) aufgestellt sind; und
Wärmeabstrahlungsrippengruppen (4, 5; 24, 25, 26) mit mehreren Rippen (4a, 5a; 24a, 25a, 26a), die an den Wärmerohren angebracht sind,
wobei
eine Kühlluftströmung in einer zum Wärmeaufnahmeblock (2, 22) parallelen Richtung hergestellt wird,
die mehreren Wärmeabstrahlungsrippengruppen (4, 5; 24, 25, 26) entlang der Strömungsrichtung der Kühlluft hintereinandergeschaltet sind, und
von den mehreren Wärmeabstrahlungsrippengruppen (4, 5; 24, 25, 26) eine Rippenteilung einer Wärmeabstrahlungsrippengruppe (4; 24), die auf einer Anströmseite der Kühlluft angeordnet ist, größer ist als eine Rippenteilung einer Wärmeabstrahlungsrippengruppe (5; 25), die auf einer Abströmseite der Kühlluft angeordnet ist,
**dadurch gekennzeichnet, dass**
bei Betrachtung der mehreren Wärmeabstrahlungsrippengruppen (4, 5; 24, 25, 26) als eine einzelne Gruppe (44) von Wärmeabstrahlungsrippen (44a), die aus mehreren Rippen (44a) besteht, die Position eines Zwischenraums (8; 28-1, 28-2) zwischen den Wärmeabstrahlungsrippengruppen (4, 5; 24, 25, 26) der Position der Oberflächentemperatur der einzelnen Gruppe (44) von Wärmeabstrahlungsrippen (44a) entspricht, welche den Temperaturunterschied auf der Oberfläche der einzelnen Gruppe (44) von Wärmeabstrahlungsrippen (44a) zwischen An- und Abströmung durch die Anzahl an Wärmeabstrahlungsrippengruppen (4, 5; 24, 25, 26) gleich unterteilt.

4. Kühlvorrichtung (1, 11, 21, 31) nach einem der Ansprüche 1 bis 3, wobei die Rippenteilung der auf der Anströmseite angeordneten Wärmeabstrahlungsrippengruppe (4, 14, 24, 34) ein ganzzahliges Vielfaches der Rippenteilung der auf der Abströmseite angeordneten Wärmeabstrahlungsrippengruppe (5, 15, 25, 35) ist.

5. Kühlvorrichtung (1, 11, 21, 31) nach einem der Ansprüche 1 bis 3, wobei eine Länge der Rippen (4a, 14a, 24a, 34a) der auf der Anströmseite angeordneten Wärmeabstrahlungsrippengruppe (4, 14, 24, 34) kürzer ist als eine Länge der Rippen (5a, 15a, 25a, 35a) der auf der Abströmseite angeordneten Wärmeabstrahlungsrippengruppe (5, 15, 25, 35).

6. Kühlvorrichtung (1, 21) nach Anspruch 3, wobei die Wärmerohre (3, 23) in Seitenansicht U-förmig oder L-förmig sind.

## Revendications

1. Dispositif de refroidissement (1, 11, 21, 31), comprenant :
un bloc récepteur de chaleur (2, 12, 22, 32) thermiquement connecté à un élément générateur de chaleur (50-1, 50-2, 50-3 ; 150-1, 150-2, 150-3 ; 250-1, 250-2, 250-3 ; 350-1, 350-2, 350-3) ; et
des groupes d'ailettes de radiation de chaleur (4, 14, 24, 34 ; 5, 15, 25, 35 ; 26, 36) comportant une pluralité d'ailettes (4a, 5a, 6a) thermiquement connectées au bloc récepteur de chaleur (2, 12, 22, 32),
sachant que
un flux d'air de refroidissement est établi dans une direction parallèle au bloc récepteur de chaleur (2, 12, 22, 32),
la pluralité de groupes d'ailettes de radiation de chaleur (4, 14, 24, 34 ; 5, 15, 25, 35 ; 26, 36) est agencée en tandem le long de la direction de flux de l'air de refroidissement, et
parmi la pluralité de groupes d'ailettes de radiation de chaleur (4, 14, 24, 34), un pas d'ailettes d'un groupe d'ailettes de radiation de chaleur (4, 14, 24, 34) agencé d'un côté au vent de l'air de refroidissement est plus grand qu'un pas d'ailettes d'un groupe d'ailettes de radiation de chaleur (5, 15, 25, 35) agencé d'un côté sous le vent de l'air de refroidissement,
**caractérisé en ce que**
lorsqu'on regarde la pluralité de groupes d'ailettes de radiation de chaleur (4, 14, 24, 34 ; 5, 15, 25, 35 ; 26, 36) comme groupe unique (44) d'ailettes de radiation de chaleur (44a) composé d'une pluralité d'ailettes (44a), la position d'un interstice (8, 18 ; 28-1, 28-2 ; 38-1, 38-2) entre les groupes d'ailettes de radiation de chaleur (4, 14, 24, 34 ; 5, 15, 25, 35 ; 26, 36) correspond à la position de la température de surface du groupe unique (44) d'ailettes de radiation de chaleur (44a) qui divise de manière égale la différence de température sur la surface du groupe unique (44) d'ailettes de radiation de chaleur (44a) entre le côté au vent et le côté sous le vent par le nombre de groupes d'ailettes de radiation de chaleur (4, 14, 24, 34 ; 5, 15, 25, 35 ; 26, 36).

2. Dispositif de refroidissement (31), comprenant :
un bloc récepteur de chaleur (32) thermiquement connecté à un élément générateur de chaleur (350-1, 350-2, 350-3) ; et
des groupes d'ailettes de radiation de chaleur (34, 35, 36) comportant une pluralité d'ailettes (34a, 35a, 36a) dressées sur une surface du bloc récepteur de chaleur (32),
sachant que
un flux d'air de refroidissement est établi dans une direction parallèle au bloc récepteur de chaleur (32),
la pluralité de groupes d'ailettes de radiation de chaleur (34, 35, 36) est agencée en tandem le long de la direction de flux de l'air de refroidissement, et
parmi la pluralité de groupes d'ailettes de radiation de chaleur (34, 35, 36), un pas d'ailettes d'un groupe d'ailettes de radiation de chaleur (34) agencé d'un côté au vent de l'air de refroidissement est plus grand qu'un pas d'ailettes d'un groupe d'ailettes de radiation de chaleur (35) agencé d'un côté sous le vent de l'air de refroidissement,
**caractérisé en ce que**
lorsqu'on regarde la pluralité de groupes d'ailettes de radiation de chaleur (34, 35, 36) comme groupe unique (44) d'ailettes de radiation de chaleur (44a) composé d'une pluralité d'ailettes (44a), la position d'un interstice (38-1, 38-2) entre les groupes d'ailettes de radiation de chaleur (34, 35, 36) correspond à la position de la température de surface du groupe unique (44) d'ailettes de radiation de chaleur (44a) qui divise de manière égale la différence de température sur la surface du groupe unique (44) d'ailettes de radiation de chaleur (44a) entre le côté au vent et le côté sous le vent par le nombre de groupes d'ailettes de radiation de chaleur (34, 35, 36).

3. Dispositif de refroidissement (1, 21), comprenant :
un bloc récepteur de chaleur (2, 22) thermiquement connecté à un élément générateur de chaleur ;
une pluralité de tuyaux de chaleur (3, 23) dressés sur une surface du bloc récepteur de chaleur (2, 22) ; et
des groupes d'ailettes de radiation de chaleur (4, 5 ; 24, 25, 26) comportant une pluralité d'ailettes (4a, 5a ; 24a, 25a, 26a) montées sur les tuyaux de chaleur,
sachant que
un flux d'air de refroidissement est établi dans une direction parallèle au bloc récepteur de chaleur (2, 22),
la pluralité de groupes d'ailettes de radiation de chaleur (4, 5 ; 24, 25, 26) est agencée en tandem le long de la direction de flux de l'air de refroidissement, et
parmi la pluralité de groupes d'ailettes de radiation de chaleur (4, 5 ; 24, 25, 26), un pas d'ailettes d'un groupe d'ailettes de radiation de chaleur (4, 24) agencé d'un côté au vent de l'air de refroidissement est plus grand qu'un pas d'ailettes d'un groupe d'ailettes de radiation de chaleur (5 ; 25) agencé d'un côté sous le vent de l'air de refroidissement,
**caractérisé en ce que**
lorsqu'on regarde la pluralité de groupes d'ailettes de radiation de chaleur (4, 5 ; 24, 25, 26) comme groupe unique (44) d'ailettes de radiation de chaleur (44a) composé d'une pluralité d'ailettes (44a), la position d'un interstice (8 ; 28-1, 28-2) entre les groupes d'ailettes de radiation de chaleur (4, 5 ; 24, 25, 26) correspond à la position de la température de surface du groupe unique (44) d'ailettes de radiation de chaleur (44a) qui divise de manière égale la différence de température sur la surface du groupe unique (44) d'ailettes de radiation de chaleur (44a) entre le côté au vent et le côté sous le vent par le nombre de groupes d'ailettes de radiation de chaleur (4, 5 ; 24, 25, 26).

4. Le dispositif de refroidissement (1, 11, 21, 31) selon l'une quelconque des revendications 1 à 3, sachant que le pas d'ailettes du groupe d'ailettes de radiation de chaleur (4, 14, 24, 34) agencé du côté au vent est un multiple entier du pas d'ailettes du groupe d'ailettes de radiation de chaleur (5, 15, 25, 35) agencé du côté sous le vent.

5. Le dispositif de refroidissement (1, 11, 21, 31) selon l'une quelconque des revendications 1 à 3, sachant qu'une longueur des ailettes (4a, 14a, 24a, 34a) du groupe d'ailettes de radiation de chaleur (4, 14, 24, 34) agencé du côté au vent est plus petite qu'une longueur des ailettes (5a, 15a, 25a, 35a) du groupe d'ailettes de radiation de chaleur (5, 15, 25, 35) agencé du côté sous le vent.

6. Le dispositif de refroidissement (1, 21) selon la revendication 3, sachant que les tuyaux de chaleur (3, 23) sont en forme de U ou en forme de L en vue latérale.
